# EUROPÄISCHE PATENTSCHRIFT

(11) **EP 1 141 834 B1**
(45) Veröffentlichungstag und Bekanntmachung des Hinweises auf die Patenterteilung: **04.09.2002**
(21) Anmeldenummer: 99966804.9
(22) Anmeldetag: 01.12.1999
(51) Int. Cl.: G06F 11/20

(54) **INTEGRIERTER SPEICHER MIT REDUNDANZ**
IC MEMORY HAVING A REDUNDANCY
MEMOIRE INTEGREE A REDONDANCE

(30) Priorität: 22.12.1998 DE 19859518
(43) Veröffentlichungstag der Anmeldung: 10.10.2001
(73) Patentinhaber: Infineon Technologies AG, 81669 München (DE)
(72) Erfinder: HÖNIGSCHMID, Heinz, East Fishkill, NY 12524 (US); BRAUN, Georg, D-80339 München (DE); MAJDIC, Andrej, D-85604 Zorneding (DE)
(74) Vertreter: Epping Hermann & Fischer
(86) Internationale Anmeldenummer: DE9903807
(87) Internationale Veröffentlichungsnummer: WO00038065

(56) Entgegenhaltungen:
- US-A- 5 761 138
- PATENT ABSTRACTS OF JAPAN vol. 1996, no. 02, 29. Februar 1996 (1996-02-29) & JP 07 272499 A (MITSUBISHI ELECTRIC CORP), 20. Oktober 1995 (1995-10-20)
- PATENT ABSTRACTS OF JAPAN vol. 013, no. 279 (P-891), 27. Juni 1989 (1989-06-27) & JP 01 066762 A (MITSUBISHI ELECTRIC CORP), 13. März 1989 (1989-03-13)

## Beschreibung

Die Erfindung betrifft einen integrierten Speicher mit Redundanz.

Es ist allgemein bekannt, defekte Speicherzellen eines Speichers durch redundante Speicherzellen zu ersetzen und auf diese Weise den Speicher zu reparieren. Die redundanten Speicherzellen sind dabei entweder entlang redundanter Wortleitungen oder redundanter Bitleitungen angeordnet. In der US 5,568,432 A ist beispielsweise ein integrierter Speicher mit einer redundanten Bitleitung beschrieben, die zum Ersetzen einer der normalen Bitleitungen, entlang derer die normalen Speicherzellen angeordnet sind, vorgesehen ist. Die normale Bitleitung ist einem Leseverstärker zugeordnet, der beim Auslesen der Speicherzellen die in ihnen gespeicherte Information verstärkt nach außerhalb des Speichers liefert. Im Redundanzfall, das heißt nach Durchführung des Ersetzens der normalen Bitleitung durch die redundante Bitleitung, sorgt eine Redundanz-Schiebeschaltung dafür, daß die redundante Bitleitung anstelle der normalen Bitleitung mit deren Leseverstärker verbunden wird.

In der US 5,568,432 A sowie in der US 5,761,138 A ist außerdem ein anderes Redundanzkonzept beschrieben, bei dem der redundanten Bitleitung bereits ein redundanter Leseverstärker zugeordnet ist, der zusätzlich zu den normalen Leseverstärkern der normalen Bitleitungen vorhanden ist. Im Redundanzfall wird die einen Defekt aufweisende normale Bitleitung mit ihrem normalen Leseverstärker durch die redundante Bitleitung mit ihrem redundanten Leseverstärker ersetzt.

Der Erfindung liegt die Aufgabe zugrunde, einen integrierten Speicher anzugeben, der Bitleitungen aufweist, die an Leseverstärker angeschlossen sind, bei dem eine Reparatur von Fehlern auf andere Weise erfolgt.

Diese Aufgabe wird mit einem integrierten Speicher gemäß Anspruch 1 gelöst. Das Reparaturverfahren gemäß Patentanspruch 7 oder Patentanspruch 8 kann vorteilhaft bei einem derartigen Speicher durchgeführt werden. Vorteilhafte Aus- und Weiterbildungen der Erfindung sind Gegenstand abhängiger Ansprüche.

Der erfindungsgemäße integrierte Speicher weist eine normale Bitleitung zum Übertragen von Daten von bzw. zu an sie angeschlossenen normalen Speicherzellen sowie einen normalen Leseverstärker, der einerseits über eine Leitung mit der normalen Bitleitung und andererseits mit einer Datenleitung verbunden ist und der zum Verstärken von aus den normalen Speicherzellen ausgelesenen Daten dient, auf. Weiterhin weist er einen redundanten Leseverstärker zum Ersetzen des normalen Leseverstärkers im Redundanzfall auf, der ebenfalls einerseits mit der Leitung und andererseits mit der Datenleitung verbunden ist und im Redundanzfall zum Verstärken der aus den normalen Speicherzellen ausgelesenen Daten dient.

Die Erfindung beruht auf der Erkenntnis, daß die beim Auslesen über eine normale Bitleitung erkannten Defekte zwar zum größten Teil auf Defekte der Bitleitung selbst bzw. der an sie angeschlossenen normalen Speicherzellen zurückzuführen sind, daß aber trotzdem auch der Fall eintreten kann, daß der mit der Bitleitung verbundene normale Leseverstärker defekt, die Bitleitung mit den daran angeschlossenen Speicherzellen jedoch intakt ist. In einem solchen Fall würde das Ersetzen der intakten Bitleitung durch eine redundante Bitleitung nicht zu einer erfolgreichen Reparatur des Speichers beitragen. Würde man dagegen sowohl den defekten Leseverstärker als auch die mit ihm verbundene Bitleitung durch redundante Elemente ersetzen, obwohl nur der normale Leseverstärker defekt ist, ergäbe sich gegenüber der hier vorgeschlagenen Lösung ein unverhältnismäßig großer Aufwand. Die Erfindung ermöglicht das Ersetzen eines defekten normalen Leseverstärkers durch einen redundanten Leseverstärker, wobei die mit dem defekten Leseverstärker verbundene normale Bitleitung nicht gleichzeitig durch eine redundante Bitleitung ersetzt werden muß. Ist lediglich der normale Leseverstärker, nicht jedoch die normale Bitleitung defekt, kann über den redundanten Leseverstärker im Redundanzfall nach wie vor auf die normale Bitleitung zugegriffen werden.

Nach einer Weiterbildung der Erfindung weist der integrierte Speicher eine redundante Bitleitung auf, die zum Ersetzen der normalen Bitleitung vorgesehen ist und ebenfalls mit der Leitung verbunden ist. Im Falle des Ersetzens der normalen Bitleitung durch die redundante Bitleitung erfolgt eine Datenübertragung von oder zu an die redundante Bitleitung angeschlossenen redundanten Speicherzellen entweder über den normalen oder den redundanten Leseverstärker. Dies ist abhängig davon, ob auch der normale durch den redundanten Leseverstärker ersetzt worden ist.

Dies hat den Vorteil, daß sowohl ein Defekt des normalen Leseverstärkers durch Verwendung des redundanten Leseverstärkers als auch ein Defekt der normalen Bitleitung durch Verwendung der redundanten Bitleitung unabhängig voneinander repariert werden können. Hierdurch ist eine große Flexibilität gewährleistet. Außerdem können die vorhandenen redundanten Ressourcen (redundanter Leseverstärker und redundante Bitleitung) am effektivsten eingesetzt werden.

Zusätzlich oder alternativ zu der eben erwähnten Ausführungsform weist der integrierte Speicher nach einer Weiterbildung eine weitere redundante Bitleitung auf, die zum Ersetzen der normalen Bitleitung vorgesehen ist und die über einen weiteren redundanten Leseverstärker mit der Datenleitung verbunden ist. Hierbei kann ein Defekt des normalen Leseverstärkers durch den redundanten Leseverstärker und ein Defekt der normalen Bitleitung durch Ersetzen der normalen Bitleitung und ihres normalen Leseverstärkers durch die redundante weitere Bitleitung und den weiteren redundanten Leseverstärker repariert werden.

Nach einer Weiterbildung weist der integrierte Speicher ein programmierbares Verbindungselement auf, über das die Leitung mit dem normalen Leseverstärker verbunden ist und ein programmierbares Verbindungselement, über das die Leitung mit dem redundanten Leseverstärker verbunden ist, wobei die Verbindungselemente in Abhängigkeit ihres Programmierzustandes elektrisch leitfähig oder elektrisch nicht leitfähig sind. Zusätzlich oder alternativ zu diesen Verbindungselementen weist der integrierte Speicher nach einer Weiterbildung ein programmierbares Verbindungselement auf, über das der normale Leseverstärker mit der Datenleitung verbunden ist und ein programmierbares Verbindungselement, über das der redundante Leseverstärker mit der Datenleitung verbunden ist, wobei auch diese Verbindungselemente in Abhängigkeit ihres Programmierzustandes ebenfalls elektrisch leitfähig oder elektrisch nicht leitfähig sind. Die Verbindungselemente ermöglichen durch entsprechende Programmierung das elektrische Abkoppeln der normalen bzw. redundanten Leseverstärker von der Leitung bzw. von der Datenleitung in Abhängigkeit davon, ob der Redundanzfall vorliegt oder nicht. Hierdurch werden Fehlfunktionen vermieden und die kapazitive Belastung für den jeweils aktivierten Leseverstärker wird minimiert.

Besonders vorteilhaft ist es, wenn die programmierbaren Verbindungselemente reversibel programmierbar sind, so daß ihre Programmierung wieder zurückgenommen bzw. aufgehoben werden kann. Dies ermöglicht im Rahmen des erfindungsgemäßen Reparaturverfahrens in einem ersten Schritt die Durchführung einer versuchsweisen Ersetzung entweder des normalen Leseverstärkers oder der normalen Bitleitung und das Rückgängigmachen dieser Reparatur in dem Fall, daß auch anschließend noch ein Defekt festgestellt wird. Daraufhin kann der nunmehr lokalisierte Defekt unter Einsatz der jeweils anderen Redundanzart, die bisher nicht zur Anwendung kam, repariert werden.

Die Erfindung wird im folgenden anhand der Figuren näher erläutert, die Ausführungsbeispiele der Erfindung zeigen. Es zeigen:
- Figur 1: ein erstes Ausführungsbeispiel des erfindungsgemäßen integrierten Speichers,
- Figur 2: ein erstes Ausführungsbeispiel des erfindungsgemäßen Reparaturverfahrens,
- Figur 3: ein zweites Ausführungsbeispiel des erfindungsgemäßen Reparaturverfahrens,
- Figur 4: ein zweites Ausführungsbeispiel des integrierten Speichers und
- Figur 5: ein Ausführungsbeispiel eines programmierbaren Verbindungselements.

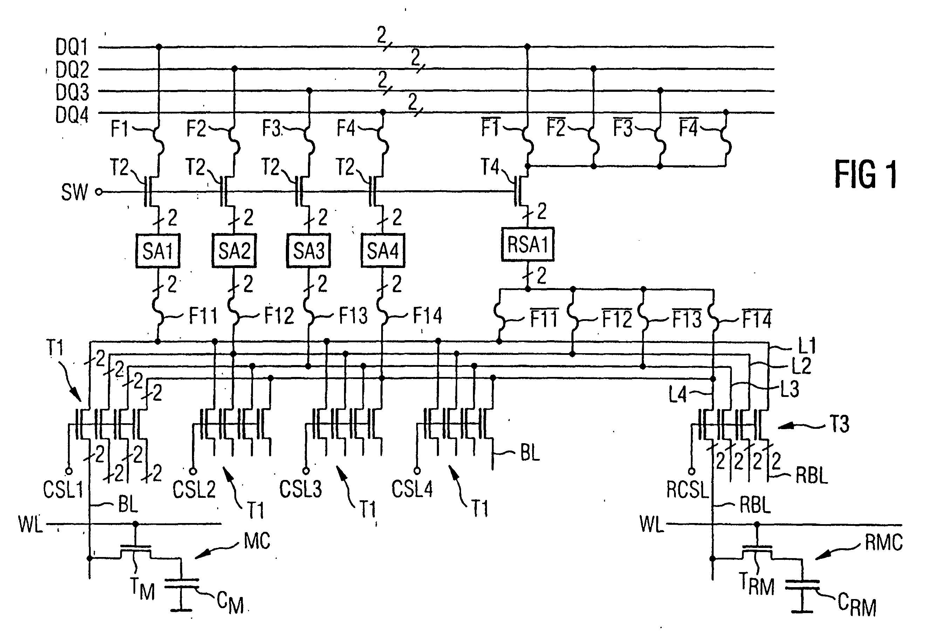

Figur 1 zeigt ein Ausführungsbeispiel des erfindungsgemäßen integrierten Speichers. Der integrierte Speicher ist ein DRAM, obwohl die Erfindung auch auf andere Speicher, die mit Bitleitungen verbundene Leseverstärker aufweisen, anwendbar ist, wie zum Beispiel FRAMs bzw. FeRAMs (ferroelektrische Speicher). Der Speicher weist vier normale Leseverstärker SAi und einen redundanten Leseverstärker RSA1 auf. Die normalen Leseverstärker SAi sind über je zwei erste programmierbare Verbindungselemente in Form von Laserfuses F11 bis F14 mit je einem Leitungspaar Li verbunden. Das DRAM hat Speicherzellen MC vom 1-Transistor-1-Kondensator-Typ mit einem Auswahltransistor T_{M} und einem Speicherkondensator C_{M}. Das Gate des Auswahltransistors T_{M} ist mit einer Wortleitung WL verbunden. Der Speicherkondensator ist mit seiner einen Elektrode mit Masse und mit seiner anderen Elektrode über die steuerbare Strecke des Auswahltransistor T_{M} mit einer Bitleitung BL verbunden. Der Speicher weist in Wirklichkeit eine große Anzahl von Wortleitungen WL und Speicherzellen MC auf, von denen jedoch in Figur 1 nur beispielhaft jeweils eine angegeben wurden. Die Speicherzellen sind matrixartig in Kreuzungspunkten der Wortleitungen und der Bitleitungen angeordnet. Figur 1 zeigt vier Gruppen von je vier Bitleitungspaaren BL. Je ein Bitleitungspaar BL aus jeder dieser Gruppen ist mit einer der Leitungspaare Li über erste Transistoren T1 vom n-Kanal-Typ verbunden. Die Gates der ersten Transistoren T1 jeder Gruppe werden über jeweils ein gemeinsames Spaltenauswahlsignal CSLi angesteuert. Zum selben Zeitpunkt ist nur eines der Spaltenauswahlsignale CSLi aktiv, so daß nur die Bitleitungspaare BL einer der Gruppen mit den vier Leitungspaaren Li verbunden werden.

Die vier normalen Leseverstärker SAi sind weiterhin über zweite Transistoren T2 vom n-Kanal-Typ und zweite programmierbare Verbindungselemente in Form von Fuses F1 bis F4 mit je einem Datenleitungspaar DQi verbunden.

Bei den Leseverstärkern SAi, RSA1 handelt es sich um differentielle Leseverstärker. Die Erfindung ist auch auf Speicher anwendbar, deren Leseverstärker nicht differentiell arbeiten, sondern jeweils nur mit einer Bitleitung statt mit einem Bitleitungspaar verbunden sind.

Weiterhin weist der Speicher in Figur 1 einen redundanten Leseverstärker RSA1 auf, der über Paare von dritten programmierbaren Verbindungselementen in Form von Laserfuses /F11 bis /F14 mit je einem der Leitungspaare Li und über Paare von vierten programmierbaren Verbindungselementen in Form von Laserfuses /F1 bis /F4 sowie ein Paar von diesen vorgeschalteten vierten Transistoren T4 mit je einem der Datenleitungspaare DQi verbunden ist.

Der integrierte Speicher in Figur 1 weist weiterhin redundante Bitleitungspaare RBL auf, die bei anderen Ausführungsbeispielen der Erfindung auch entfallen können. Die vier redundanten Bitleitungspaare RBL sind mit einer Vielzahl von redundanten Speicherzellen RMC verbunden, von denen in Figur 1 eine beispielhaft dargestellt wurde. Sie ist mit einer der redundanten Bitleitungen eines der redundanten Bitleitungspaare verbunden. Die redundanten Speicherzellen RMC sind ebenso wie die normalen Speicherzellen MC aufgebaut und weisen einen Auswahltransistor T_{RM} und einen Speicherkondensator C_{RM} auf. Der Auswahltransistor T_{RM} der redundanten Speicherzellen RMC ist mit seinem Gate mit einer der Wortleitungen WL verbunden. Jedes redundante Bitleitungspaar RBL ist über entsprechende dritte Transistoren T3 mit einem der Leitungspaare Li verbunden. Gates der dritten Transistoren T3 sind mit einem redundanten Spaltenauswahlsignal RCSL verbunden.

Hat der in Figur 1 gezeigte Speicher keinen Defekt, werden die ersten Verbindungselemente F11 bis F14 und die zweiten Verbindungselemente F1 bis F4 nicht aufgetrennt, während die dritten Verbindungselemente /F11 bis /F14 und die vierten Verbindungselemente /F1 bis /F4 aufgetrennt werden. Somit ist der redundante Leseverstärker RSA1 vollständig von den Leitungspaaren Li und den Datenleitungspaaren DQi abgekoppelt und beeinflußt den Betrieb des Speichers nicht mehr. Wird jedoch festgestellt, daß einer der normalen Leseverstärker SAi defekt ist, beispielsweise der normale Leseverstärker SA1 ganz links in Figur 1, wird das mit ihm verbundene erste Verbindungselement F11 und das mit ihm verbundene zweite Verbindungselement F1 aufgetrennt, während beim redundanten Leseverstärker SA1 die Verbindungselemente /F2 bis /F4 sowie /F12 bis /F14 aufgetrennt werden, die Verbindungselemente /F1 und /F11 jedoch nicht aufgetrennt werden. Da die Gates der zweiten Transistoren T2 und des vierten Transistors T4 über ein gemeinsames Auswahlsignal SW angesteuert werden, kann der redundante Leseverstärker RSA1 auf diese Weise den normalen Leseverstärker SA1 vollständig ersetzen. Ist einer der anderen normalen Leseverstärker SA2 bis SA4 defekt, der erste normale Leseverstärker SA jedoch intakt, werden die elektrischen Verbindungselemente auf entsprechende Weise aufgetrennt, um eine Reparatur durchzuführen.

Durch das Vorhandensein der redundanten Bitleitungspaare RBL beim Speicher in Figur 1 ist es darüber hinaus möglich, auch einen Defekt auf einem oder mehreren der Bitleitungspaare BL einer der vier Gruppen zu reparieren. Zu diesem Zweck wird eine Aktivierung der den Defekt aufweisenden Gruppe über ihr Spaltenauswahlsignal CSLi unterbunden, und stattdessen die redundante Bitleitungsgruppe über ihr redundantes Spaltenauswahlsignal RCSL aktiviert. Der in Figur 1 gezeigte Speicher bietet also die Möglichkeit, Defekte eines seiner Leseverstärker SAi und Defekte innerhalb einer seiner Bitleitungsgruppen unabhängig voneinander mit Hilfe des redundanten Leseverstärkers RSA1 bzw. der redundanten Bitleitungen RBL zu reparieren.

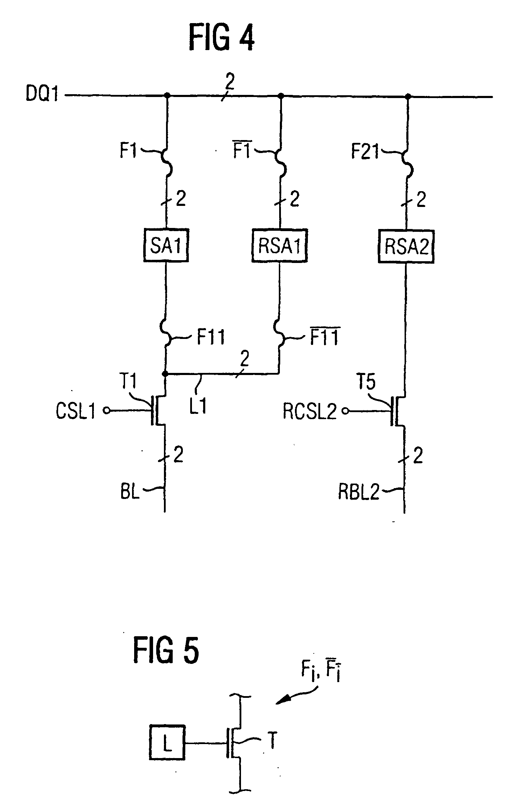

Vorteilhaft ist es, wenn es sich bei den in Figur 1 eingezeichneten programmierbaren Verbindungselementen F1 bis /F14 um reversibel programmierbare Elemente handelt. Dann können zum Beispiel in einem Grundzustand des integrierten Speichers nach seiner Herstellung zunächst die Verbindungselemente F1 bis F14 leitend und die Verbindungselemente /F1 bis /F14 nicht leitend sein und eine entsprechende Umprogrammierung in Abhängigkeit von im Rahmen eines Speichertests festgestellten Defekten erfolgen. Figur 5 zeigt ein derartiges reversibel programmierbares Verbindungselement Fi; /Fi. Es weist einen n-Kanal-Transistor T auf, dessen steuerbare Kanalstrecke beim Ausführungsbeispiel aus Figur 1 anstelle der dort eingezeichneten Laser-Fuses anzuordnen ist. Sein Gate ist mit dem Ausgang eines programmierbaren Registers L verbunden, in dem wahlweise ein hohes oder ein niedriges Potential gespeichert werden kann. Ist im Register L ein hohes Potential gespeichert, ist das programmierbare Verbindungselement Fi elektrisch leitend. Im umgekehrten Fall ist es elektrisch nicht leitend.

Figur 4 zeigt ein anderes Ausführungsbeispiel des integrierten Speichers, bei dem ein normales Bitleitungspaar BL über erste Transistoren T1 wiederum mit einem Leitungspaar L1 verbunden ist. Dem Gate des ersten Transistors T1 ist wieder ein Spaltenauswahlsignal CSL1 zugeführt. Das Leitungspaar L1 ist über programmierbare Verbindungselemente F11, /F11 einerseits mit einem normalen Leseverstärker SA1 und andererseits mit einem redundanten Leseverstärker RSA1 verbunden. Der normale Leseverstärker SA1 ist über ein Paar von programmierbaren Verbindungselementen F1 mit einem Datenleitungspaar DQ1 verbunden. Der redundante Leseverstärker RSA1 ist über ein Paar von programmierbaren Verbindungselementen /F1 mit dem Datenleitungspaar DQ1 verbunden. Weiterhin weist der Speicher in Figur 4 ein redundantes Bitleitungspaar RBL2 auf, das über zwei fünfte Transistoren T5 mit einem weiteren redundanten Leseverstärker RSA2 verbunden ist. Die Gates der fünften Transistoren T5 sind mit einem redundanten Spaltenauswahlsignal RCSL2 verbunden. Der weitere redundante Leseverstärker RSA2 ist über ein Paar von programmierbaren Verbindungselementen F21 mit dem Datenleitungspaar DQ1 verbunden. Bei den in Figur 4 eingezeichneten programmierbaren Verbindungselementen F1, /F1, F11, /F11, F21 kann es sich beispielsweise wiederum um Laserfuses handeln. Vorteilhafterweise handelt es sich aber um reversibel programmierbare Verbindungselemente von der anhand Figur 5 bereits erläuterten Art.

Beim in Figur 4 gezeigten Speicher ist es möglich, bei einem Defekt des normalen Leseverstärkers SA1 diesen durch den redundanten Leseverstärker RSA1, der ihm parallel geschaltet ist, zu ersetzen. Wenn keine derartige Ersetzung vorgenommen werden soll, ist es zweckmäßig, die Verbindungselemente /F1 und /F11 nicht leitend zu schälten bzw. aufzutrennen. Soll dagegen der redundante Leseverstärker RSA1 anstelle des normalen Leseverstärkers SA1 verwendet werden, werden die Verbindungselemente F1 und F11 nicht leitend geschaltet. Dient das redundante Bitleitungspaar RBL2 nicht dem Ersetzen des normalen Bitleitungspaares BL, ist auch das Verbindungselement F21 nicht leitend geschaltet. Handelt es sich dagegen um einen Defekt des normalen Bitleitungspaares BL bzw. von mit diesem verbundenen normalen Speicherzellen, wird der normale Leseverstärker SA1 nicht durch den redundanten Leseverstärker RSA1 ersetzt, sondern der normale Leseverstärker SA1 und das normale Bitleitungspaar BL werden gemeinsam durch den weiteren redundanten Leseverstärker RSA2 und das redundante Bitleitungspaar RBL2 ersetzt. Dann wird die Aktivierung des Spaltenauswahlsignals CSL1 unterdrückt und stattdessen zum gleichen Zeitpunkt das redundante Spaltenauswahlsignal RCSL2 aktiviert. In diesem Fall ist das Verbindungselement F21 permanent leitend geschaltet und die Verbindungselemente F1, /F1, F11 und /F11 werden nicht leitend geschaltet.

Die geschilderten Ausführungsbeispiele haben den Vorteil, daß ein Defekt eines der normalen Leseverstärker SAi durch den redundanten Leseverstärker RSA1 repariert werden kann, ohne daß redundante Bitleitungen RBL2 verwendet werden müssen. Die Verwendung der normalen Bitleitungen BL ist durch die Verwendung des redundanten Leseverstärkers RSA1 weiter möglich. Daher können die redundanten Bitleitungen RBL2 zur Reparatur defekter normaler Bitleitungen BL verwendet werden, die mit einem anderen normalen Leseverstärker SAi verbunden sind (in Figur 4 nicht dargestellt). Es ist zu beachten, daß insbesondere Figur 4 nur einen kleinen Ausschnitt eines realen Speichers zeigt, der in Wirklichkeit eine viel größere Anzahl von normalen Leseverstärkern SAi aufweist. Figur 4 ist also nicht so zu verstehen, daß jedem normalen Bitleitungspaar BL und dem damit verbundenen normalen Leseverstärker SA1 sowohl ein separater redundanter Leseverstärker RSA1 ohne redundante Bitleitung und ein weiterer separater redundanter Leseverstärker RSA2 mit redundanten Bitleitungen RBL2 zugeordnet ist. Vielmehr wird in der Praxis der redundante Leseverstärker RSA1 mehreren normalen Leseverstärkern SAi zugeordnet, wie beispielsweise Figur 1 entnehmbar ist. Ebenso kann der weitere redundante Leseverstärker RSA2 vorzugsweise einer Vielzahl von normalen Leseverstärkern SAi mit den zugehörigen normalen Bitleitungspaaren BL zugeordnet sein, von denen er jeweils einen ersetzen kann.

Bei den zuvor beschriebenen Speichern ist es möglich, einen Speichertest durchzuführen, bei dem Daten über die Datenleitungspaare DQi und die normalen Leseverstärker SAi, die Leitungspaare Li sowie die normalen Bitleitungspaare BL in die Speicherzellen MC eingeschrieben werden und anschließend aus diesen wieder in umgekehrter Richtung ausgelesen werden. Werden dabei Defekte festgestellt und kann ermittelt werden, ob ein solcher Defekt einen der normalen Leseverstärker SAi oder eines der normalen Bitleitungspaare BL betrifft, kann in Abhängigkeit dieses Testergebnisses gezielt der betreffende normale Leseverstärker SAi durch den redundanten Leseverstärker RSA1 oder das betreffende defekte normale Bitleitungspaar BL bzw. die gesamte Bitleitungsgruppe von je vier Bitleitungspaaren BL durch die entsprechenden redundanten Bitleitungen RBL ersetzt werden.

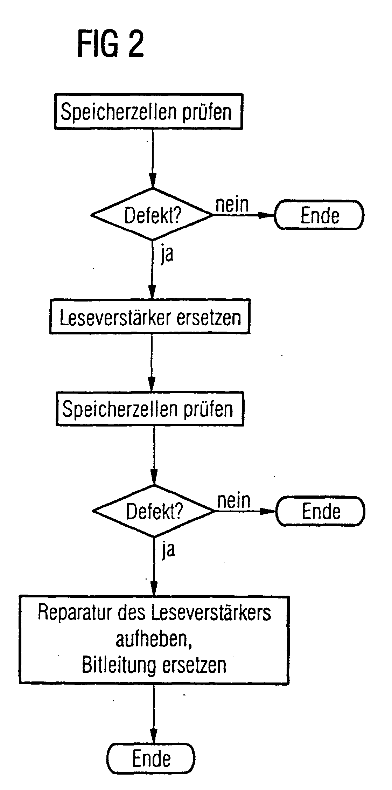

In Figur 2 ist ein Ausführungsbeispiel eines Reparaturverfahrens für den integrierten Speicher aus Figur 1 dargestellt, der reversibel programmierbare Verbindungselemente F1 bis /F14 gemäß Figur 5 aufweist. Zunächst werden die Speicherzellen MC durch Einschreiben und Auslesen von Daten über die normalen Leseverstärker SAi geprüft. Wird dabei kein Defekt festgestellt, wird die Prüfung beendet und der Speicher als intakt deklariert. Wird dagegen ein Defekt festgestellt, und es ist unklar, ob dieser auf einem Defekt des betreffenden normalen Leseverstärkers SAi oder einer der Bitleitungen BL bzw. der mit dieser verbundenen Speicherzellen MC beruht, wird der betreffende normale Leseverstärker SAi durch den redundanten Leseverstärker RSA1 ersetzt. Anschließend wird die Überprüfung derjenigen Speicherzellen wiederholt, bei denen zuvor ein Defekt festgestellt worden ist. Konnte der Defekt dadurch behoben werden, lag der Fehler tatsächlich am ersetzten normalen Leseverstärker SAi und das Reparaturverfahren kann beendet werden. Ist der Defekt jedoch weiterhin vorhanden, wird die Reparatur des normalen Leseverstärkers SAi durch den redundanten Leseverstärker RSA1 aufgehoben bzw. rückgängig gemacht und es werden die mit diesem normalen Leseverstärker SAi verbundenen normalen Bitleitungen BL durch die redundanten Bitleitungen RBL ersetzt. Anschließend wird das Reparaturverfahren beendet, da der Fehler offensichtlich nicht beim normalen Leseverstärker SAi, sondern bei einer seiner Bitleitungen BL lag.

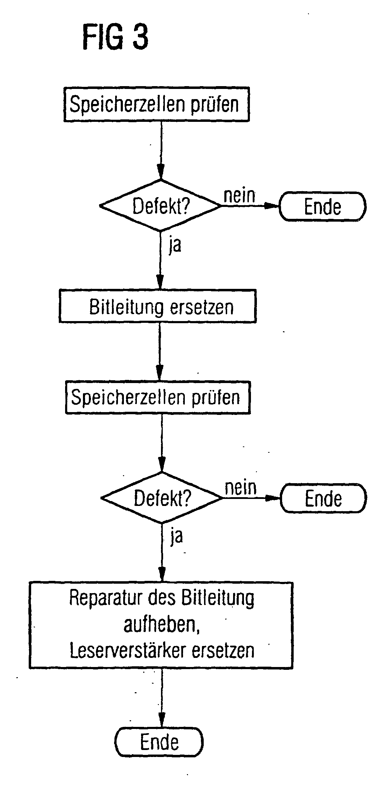

Figur 3 zeigt ein anderes Reparaturverfahren für den Speicher aus Figur 1. Wiederum werden die Speicherzellen durch Einschreiben und Auslesen von Daten auf die oben beschriebene Art geprüft. Wird dabei ein Defekt festgestellt, und es ist unklar, ob einer der normalen Leseverstärker SAi oder die mit diesem verbundenen normalen Bitleitungen BL defekt sind, werden bei diesem Verfahren zunächst die entsprechenden normalen Bitleitungen BL durch die redundanten Bitleitungen RBL ersetzt.

Anschließend werden diejenigen Speicherzellen, bei deren Prüfung zuvor ein Defekt festgestellt wurde, erneut geprüft. Wird dabei kein Defekt festgestellt, war die Reparatur offensichtlich erfolgreich und der Defekt befand sich tatsächlich auf einer der ersetzten normalen Bitleitungen. Wird jedoch weiterhin ein Defekt festgestellt, wird die Reparatur der Bitleitungen aufgehoben und stattdessen der entsprechende normale Leseverstärker SAi durch den redundanten Leseverstärker RSA1 ersetzt. Der festgestellte Defekt kann offensichtlich nur noch durch den ersetzten normalen Leseverstärker SAi bedingt gewesen sein. Damit ist dieses Reparaturverfahren abgeschlossen.

Bei den Reparaturverfahren gemäß den Figuren 2 und 3 erfolgt in Abhängigkeit der jeweils durchgeführten Reparatur eine Programmierung der programmierbaren Verbindungselemente F1,...,/F14. Diese sind zum Ermöglichen des Aufhebens der Reparatur vorzugsweise reversibel programmierbar, beispielsweise vom in Figur 5 dargestellten Typ. Ihre Programmierung wird während der Durchführung des gewählten Reparaturverfahrens unter Umständen mehrfach geändert.

## Patentansprüche

1. Integrierter Speicher
- mit einer normalen Bitleitung (BL) zum Übertragen von Daten von bzw. zu an sie angeschlossenen normalen Speicherzellen (MC),
- mit einem normalen Leseverstärker (SA1), der einerseits über eine Leitung (L1) mit der normalen Bitleitung (BL) und andererseits mit einer Datenleitung (DQ1) verbunden ist und der zum Verstärken von aus den normalen Speicherzellen (MC) ausgelesenen Daten dient,
- und mit einem redundanten Leseverstärker (RSA1) zum Ersetzen des normalen Leseverstärkers (SA1) im Redundanzfall, der ebenfalls einerseits mit der Leitung (L1) und andererseits mit der Datenleitung (DQ1) verbunden ist und im Redundanzfall zum Verstärken der aus den normalen Speicherzellen (MC) ausgelesenen Daten dient.

2. Integrierter Speicher nach Anspruch 1,
- mit einer redundanten Bitleitung (RBL), die zum Ersetzen der normalen Bitleitung (BL) vorgesehen ist und ebenfalls mit der Leitung (L1) verbunden ist,
- bei dem im Falle des Ersetzens der normalen Bitleitung (BL) durch die redundante Bitleitung (RBL) eine Datenübertragung von oder zu an die redundante Bitleitung (RBL) angeschlossenen redundanten Speicherzellen (RMC) entweder über den normalen (SA1) oder den redundanten (RSA1) Leseverstärker erfolgt.

3. Integrierter Speicher nach Anspruch 1,
mit einer weiteren redundanten Bitleitung (RBL2), die zum Ersetzen der normalen Bitleitung (BL) vorgesehen ist und die über einen weiteren redundanten Leseverstärker (RSA2) mit der Datenleitung (DQ1) verbunden ist.

4. Integrierter Speicher nach Anspruch 1,
- mit einem programmierbaren Verbindungselement (F11), über das die Leitung (L1) mit dem normalen Leseverstärker (SA1) verbunden ist,
- und mit einem programmierbaren Verbindungselement (/F11), über das die Leitung (L1) mit dem redundanten Leseverstärker (RSA1) verbunden ist,
- wobei die Verbindungselemente in Abhängigkeit ihres Programmierzustandes elektrisch leitfähig oder elektrisch nicht leitfähig sind.

5. Integrierter Speicher nach Anspruch 1,
- mit einem programmierbaren Verbindungselement (F1), über das der normale Leseverstärker (SA1) mit der Datenleitung (DQ1) verbunden ist,
- und mit einem programmierbaren Verbindungselement (/F1), über das der redundante Leseverstärker (RSA1) mit der Datenleitung (DQ1) verbunden ist,
- wobei die Verbindungselemente in Abhängigkeit ihres Programmierzustandes elektrisch leitfähig oder elektrisch nicht leitfähig sind.

6. Integrierter Speicher nach Anspruch 4 oder 5,
dessen programmierbare Verbindungselemente (F11, /F11, F1, /F1) reversibel programmierbar sind.

7. Verfahren zur Reparatur eines integrierten Speichers, der
- eine normale Bitleitung (BL) zum Übertragen von Daten von bzw. zu an sie angeschlossenen normalen Speicherzellen (MC),
- einen normalen Leseverstärker (SA1), der einerseits über eine Leitung (L1) mit der normalen Bitleitung (BL) und andererseits mit einer Datenleitung (DQ1) verbunden ist und zum Verstärken von aus den normalen Speicherzellen (MC) ausgelesenen Daten dient,
- einen redundanten Leseverstärker (RSA1) zum Ersetzen des normalen Leseverstärkers (SA1) im Redundanzfall, der ebenfalls einerseits mit der Leitung (L1) und andererseits mit der Datenleitung (DQ1) verbunden ist und im Redundanzfall zum Verstärken der aus den normalen Speicherzellen (MC) ausgelesenen Daten dient,
- und eine redundante Bitleitung (RBL) zum Ersetzen der normalen Bitleitung (BL) aufweist,
mit folgenden Schritten:
- der normale Leseverstärker (SA1) und die normale Bitleitung (BL) mit den daran angeschlossenen normalen Speicherzellen (MC) werden geprüft,
- bei einem Defekt des normalen Leseverstärkers (SA1) wird dieser durch den redundanten Leseverstärker (RSA1) und bei einem Defekt der normalen Bitleitung (BL) bzw. einer der normalen Speicherzellen (MC) wird diese durch die redundante Bitleitung (RBL) ersetzt,
- die normalen Speicherzellen (MC) der normalen Bitleitung (BL) werden durch Beschreiben und Auslesen über den normalen Leseverstärker (SA1) geprüft,
- im Falle eines Defektes wird die normale Bitleitung (BL) durch die redundante Bitleitung (RBL) ersetzt,
- die redundanten Speicherzellen (RMC) der redundanten Bitleitung (RBL) werden durch Beschreiben und Auslesen über den normalen Leseverstärker (SA1) geprüft,
- wenn dabei erneut ein Defekt festgestellt wird, wird das Ersetzen der normalen Bitleitung (BL) durch die redundante Bitleitung (RBL) rückgängig gemacht und der normale Leseverstärker (SA1) wird durch den redundanten Leseverstärker (RSA1) ersetzt.

8. Verfahren zur Reparatur eines integrierten Speichers, der
- eine normale Bitleitung (BL) zum Übertragen von Daten von bzw. zu an sie angeschlossenen normalen Speicherzellen (MC),
- einen normalen Leseverstärker (SA1), der einerseits über eine Leitung (L1) mit der normalen Bitleitung (BL) und andererseits mit einer Datenleitung (DQ1) verbunden ist und zum Verstärken von aus den normalen Speicherzellen (MC) ausgelesenen Daten dient,
- einen redundanten Leseverstärker (RSA1) zum Ersetzen des normalen Leseverstärkers (SA1) im Redundanzfall, der ebenfalls einerseits mit der Leitung (L1) und andererseits mit der Datenleitung (DQ1) verbunden ist und im Redundanzfall zum Verstärken der aus den normalen Speicherzellen (MC) ausgelesenen Daten dient,
- und eine redundante Bitleitung (RBL) zum Ersetzen der normalen Bitleitung (BL) aufweist,
mit folgenden Schritten:
- der normale Leseverstärker (SA1) und die normale Bitleitung (BL) mit den daran angeschlossenen normalen Speicherzellen (MC) werden geprüft,
- bei einem Defekt des normalen Leseverstärkers (SA1) wird dieser durch den redundanten Leseverstärker (RSA1) und bei einem Defekt der normalen Bitleitung (BL) bzw. einer der normalen Speicherzellen (MC) wird diese durch die redundante Bitleitung (RBL) ersetzt,
- die normalen Speicherzellen (MC) der normalen Bitleitung (BL) werden durch Beschreiben und Auslesen über den normalen Leseverstärker (SA1) geprüft,
- im Falle eines Defektes wird der normale Leseverstärker (SA1) durch den redundanten Leseverstärker (RSA1) ersetzt,
- die normalen Speicherzellen (MC) der normalen Bitleitung (BL) werden durch Beschreiben und Auslesen über den redundanten Leseverstärker (RSA1) geprüft,
- wenn dabei erneut ein Defekt.festgestellt wird, wird das Ersetzen des normalen Leseverstärkers (SA) durch den redundanten Leseverstärker (RSA1) rückgängig gemacht und die normale Bitleitung (BL) wird durch die redundante Bitleitung (RBL) ersetzt.

## Claims

1. Integrated memory
- having a normal bit line (BL) for transferring data from or to normal memory cells (MC) connected to it,
- having a normal sense amplifier (SA1), which on the one hand is connected via a line (L1) to the normal bit line (BL) and on the other hand is connected to a data line (DQ1) and which serves for amplifying data read from the normal memory cells (MC),
- and having a redundant sense amplifier (RSA1) for replacing the normal sense amplifier (SA1) in the redundancy situation, which is likewise connected on the one hand to the line (L1) and on the other hand to the data line (DQ1) and, in the redundancy situation, serves for amplifying the data read from the normal memory cells (MC).

2. Integrated memory according to Claim 1,
- having a redundant bit line (RBL), which is provided for replacing the normal bit line (BL) and is likewise connected to the line (L1),
- in which, in the event of the normal bit line (BL) being replaced by the redundant bit line (RBL), a data transfer from or to redundant memory cells (RMC) connected to the redundant bit line (RBL) is effected either via the normal (SA1) or the redundant (RSA1) sense amplifier.

3. Integrated memory according to Claim 1,
having a further redundant bit line (RBL2), which is provided for replacing the normal bit line (BL) and which is connected to the data line (DQ1) via a further redundant sense amplifier (RSA2).

4. Integrated memory according to Claim 1,
- having a programmable connection element (F11), via which the line (L1) is connected to the normal sense amplifier (SA1),
- and having a programmable connection element (/F11), via which the line (L1) is connected to the redundant sense amplifier (RSA1),
- the connection elements being electrically conductive or electrically nonconductive depending on their programming state.

5. Integrated memory according to Claim 1,
- having a programmable connection element (F1), via which the normal sense amplifier (SA1) is connected to the data line (DQ1),
- and having a programmable connection element (/F1), via which the redundant sense amplifier (RSA1) is connected to the data line (DQ1),
- the connection elements being electrically conductive or electrically nonconductive depending on their programming state.

6. Integrated memory according to Claim 4 or 5, whose programmable connection elements (F11, /F11, F1, /F1) are reversibly programmable.

7. Method for repairing an integrated memory having
- a normal bit line (BL) for transferring data from or to normal memory cells (MC) connected to it,
- a normal sense amplifier (SA1), which on the one hand is connected via a line (L1) to the normal bit line (BL) and on the other hand is connected to a data line (DQ1) and which serves for amplifying data read from the normal memory cells (MC),
- a redundant sense amplifier (RSA1) for replacing the normal sense amplifier (SA1) in the redundancy situation, which is likewise connected on the one hand to the line (L1) and on the other hand to the data line (DQ1) and, in the redundancy situation, serves for amplifying the data read from the normal memory cells (MC),
- and a redundant bit line (RBL) for replacing the normal bit line (BL),
having the following steps:
- the normal sense amplifier (SA1) and the normal bit line (BL) with the normal memory cells (MC) connected thereto are tested,
- in the case of a defect of the normal sense amplifier (SA1), the latter is replaced by the redundant sense amplifier (RSA1) and, in the case of a defect of the normal bit line (BL) or one of the normal memory cells (MC), said bit line is replaced by the redundant bit line (RBL),
- the normal memory cells (MC) of the normal bit line (BL) are tested by being written to and read from via the normal sense amplifier (SA1),
- in the event of a defect, the normal bit line (BL) is replaced by the redundant bit line (RBL),
- the redundant memory cells (RMC) of the redundant bit line (RBL) are tested by being written to and read from via the normal sense amplifier (SA1),
- if a defect is again ascertained in the process, the replacement of the normal bit line (BL) by the redundant bit line (RBL) is reversed and the normal sense amplifier (SA1) is replaced by the redundant sense amplifier (RSA1).

8. Method for repairing an integrated memory having
- a normal bit line (BL) for transferring data from or to normal memory cells (MC) connected to it,
- a normal sense amplifier (SA1), which on the one hand is connected via a line (L1) to the normal bit line (BL) and on the other hand is connected to a data line (DQ1) and which serves for amplifying data read from the normal memory cells (MC),
- a redundant sense amplifier (RSA1) for replacing the normal sense amplifier (SA1) in the redundancy situation, which is likewise connected on the one hand to the line (L1) and on the other hand to the data line (DQ1) and, in the redundancy situation, serves for amplifying the data read from the normal memory cells (MC),
- and a redundant bit line (RBL) for replacing the normal bit line (BL),
having the following steps:
- the normal sense amplifier (SA1) and the normal bit line (BL) with the normal memory cells (MC) connected thereto are tested,
- in the case of a defect of the normal sense amplifier (SA1), the latter is replaced by the redundant sense amplifier (RSA1) and, in the case of a defect of the normal bit line (BL) or one of the normal memory cells (MC), said bit line is replaced by the redundant bit line (RBL),
- the normal memory cells (MC) of the normal bit line (BL) are tested by being written to and read from via the normal sense amplifier (SA1),
- in the event of a defect, the normal sense amplifier (SA1) is replaced by the redundant sense amplifier (RSA1),
- the normal memory cells (MC) of the normal bit line (BL) are tested by being written to and read from via the redundant sense amplifier (RSA1),
- if a defect is again ascertained in the process, the replacement of the normal sense amplifier (SA) by the redundant sense amplifier (RSA1) is reversed and the normal bit line (BL) is replaced by the redundant bit line (RBL).

## Revendications

1. Mémoire intégrée
- comprenant une ligne (BL) normale de bits, de transmission de données provenant de cellules (MC) normales de mémoire qui y sont raccordées et y allant,
- comprenant un amplificateur (SA1) normal de lecture qui est relié, d'une part, par une ligne (L1) à la ligne (BL) normale de bits et, d'autre part, à une ligne (DQ1) de données et qui sert à amplifier des données lues dans les cellules (MC) normales de mémoire,
- et comprenant un amplificateur (RSA1) redondant de lecture, destiné à remplacer l'amplificateur (SA1) normal de lecture en cas de redondance, qui est relié également, d'une part, à la ligne (L1) et, d'autre part, à la ligne (DQ1) de données et qui sert, en cas de redondance, à amplifier les données lues dans les cellules (MC) normales de mémoire.

2. Mémoire intégrée suivant la revendication 1
- comprenant une ligne (RBL) redondante de bits qui est prévue pour remplacer la ligne (BL) normale de bits et qui est reliée également à la ligne (L1),
- dans laquelle, dans le cas du remplacement de la ligne (BL) normale de bits par la ligne (RBL) redondante de bits, il s'effectue une transmission de données en provenance des cellules (RMC) redondantes de mémoire reliées à la ligne (RBL) redondante de bits ou y allant, soit par l'amplificateur (SA1) normal de lecture, soit par l'amplificateur (RSA1) redondant de lecture.

3. Mémoire intégrée suivant la revendication 1, comprenant une autre ligne (RBL2) redondante de bits qui est prévue pour remplacer la ligne (BL) normale de bits et qui est reliée par un autre amplificateur (RSA2) redondant de lecture à la ligne (DQ1) de données.

4. Mémoire intégrée suivant la revendication 1,
- comprenant un élément (F11) de liaison programmable, par lequel la ligne (L1) est reliée à l'amplificateur (SA1) normal de lecture,
- et comprenant un élément (/F11) de liaison programmable, par lequel la ligne (L1) est reliée à l'amplificateur (RSA1) redondant de lecture,
- les éléments de liaison étant aptes à conduire l'électricité ou inaptes à conduire l'électricité en fonction de leur état de programmation.

5. Mémoire intégrée suivant la revendication 1,
- comprenant un élément (F1) de liaison programmable, par lequel l'amplificateur (SA1) normal de lecture est relié à la ligne (DQ1) de données,
- et comprenant un élément (/F1) de liaison programmable, par lequel l'amplificateur (RSA1) redondant de lecture est relié à la ligne (DQ1) de données,
- les éléments de liaison étant aptes à conduire l'électricité ou inaptes à conduire l'électricité en fonction de leur état de programmation.

6. Mémoire intégrée suivant la revendication 4 ou 5, dont les éléments (F11, /F11, F1, /F1) de liaison programmables peuvent être programmés de manière réversible.

7. Procédé de réparation d'une mémoire intégrée qui comprend
- une ligne (BL) normale de bits
- comprenant une ligne (BL) normale de bits de transmission de données provenant de cellules (MC) normales de mémoire qui y sont raccordées et y allant,
- comprenant un amplificateur (SA1) normal de lecture qui est relié, d'une part, par une ligne (L1) à la ligne (BL) normale de bits et, d'autre part, à une ligne (DQ1) de données et qui sert à amplifier des données lues dans les cellules (MC) normales de mémoire,
- et comprenant un amplificateur (RSA1) redondant de lecture qui est relié également, d'une part, à la ligne (L1) et, d'autre part, à la ligne (DQ1) de données et sert, en cas de redondance, à amplifier les données lues dans les cellules (MC) normales de mémoire.
- et une ligne (RBL) redondante de bits pour remplacer la ligne (BL) normale de bits,
comprenant les stades suivants :
- on contrôle l'amplificateur (SA1) normal de lecture et la ligne (BL) normale de bits avec les cellules (MC) normales de mémoire qui y sont reliées,
- s'il y a un défaut de l'amplificateur (SA1) normal de lecture, on le remplace par l'amplificateur (RSA1) redondant de lecture, et s'il y a un défaut de la ligne (BL) normale de bits ou de l'une des cellules (MC) normales de mémoire, on la remplace par la ligne (RBL) redondante de bits,
- on contrôle les cellules (MC) normales de mémoire de la ligne (BL) normale de bits en écrivant et en lisant par l'intermédiaire de l'amplificateur (SA1) normal de lecture,
- s'il y a un défaut, on remplace la ligne (BL) normale de bits par la ligne (RBL) redondante de bits,
- on contrôle les cellules (RMC) redondantes de mémoire de la ligne (RBL) redondante de bits en écrivant et en lisant par l'intermédiaire de l'amplificateur (SA1) normal de lecture,
- si l'on constate à nouveau un défaut, on revient sur le remplacement de la ligne (BL) normale de bits par la ligne (RBL) redondante de bits et on remplace l'amplificateur (SA1) normal de lecture par l'amplificateur (RSA1) redondant de lecture.

8. Procédé de réparation d'une mémoire intégrée qui comprend
- une ligne (BL) normale de bits
- comprenant une ligne (BL) normale de bits de transmission de données provenant de cellules (MC) normales de mémoire qui y sont raccordées et y allant,
- comprenant un amplificateur (SA1) normal de lecture qui est relié, d'une part, par une ligne (L1) à la ligne (BL) normale de bits et, d'autre part, à une ligne (DQ1) de données et qui sert à amplifier des données lues dans les cellules (MC) normales de mémoire,
- et comprenant un amplificateur (RSA1) redondant de lecture qui est relié également, d'une part, à la ligne (L1) et, d'autre part, à la ligne (DQ1) de données et sert, en cas de redondance, à amplifier les données lues dans les cellules (MC) normales de mémoire.
- et une ligne (RBL) redondante de bits pour remplacer la ligne (BL) normale de bits,
comprenant les stades suivants :
- on contrôle l'amplificateur (SA1) normal de lecture et la ligne (BL) normale de bits avec les cellules (MC) normales de mémoire qui y sont reliées,
- s'il y a un défaut de l'amplificateur (SA1) normal de lecture, on le remplace par l'amplificateur (RSA1) redondant de lecture, et s'il y a un défaut de la ligne (BL) normale de bits ou de l'une des cellules (MC) normales de mémoire, on la remplace par la ligne (RBL) redondante de bits,
- on contrôle les cellules (MC) normales de mémoire de la ligne (BL) normale de bits en écrivant et en lisant par l'intermédiaire de l'amplificateur (SA1) normal de lecture,
- dans le cas d'un défaut, on remplace l'amplificateur (SA1) normal de lecture par l'amplificateur (RSA1) redondant de lecture,
- on contrôle les cellules (MC) normales de mémoire de la ligne (BL) normale de bits en écrivant et en lisant par l'intermédiaire de l'amplificateur (RSA1) redondant de lecture,
- si l'on constate à nouveau un défaut, on revient sur le remplacement de l'amplificateur (SA1) normal de lecture par l'amplificateur (RSA1) redondant de lecture et on remplace la ligne (BL) normale de bits par la ligne (RBL) redondante de bits.
